# FASCICULE DE BREVET EUROPEEN

(11) **EP 0 915 480 B1**
(45) Date de publication et mention de la délivrance du brevet: **12.03.2003**
(21) Numéro de dépôt: 98410119.6
(22) Date de dépôt: 16.10.1998
(51) Int. Cl.: G11C 17/16

(54) **Point mémoire MOS**
Nichtflüchtiger MOS-Speicher
Non-volatile MOS memory

(30) Priorité: 20.10.1997 FR 9713317
(43) Date de publication de la demande: 12.05.1999
(73) Titulaire: STMicroelectronics S.A., 92120 Montrouge (FR)
(72) Inventeur: Papadas, Constantin, 38610 Gieres (FR); Schoellkopf, Jean-Pierre, 38000 Grenoble (FR)
(74) Mandataire: de Beaumont, Michel

(56) Documents cités:
- EP-A- 0 712 137
- US-A- 4 353 083
- US-A- 4 935 645

## Description

La présente invention vise à réaliser un point mémoire permanent compatible avec une technologie CMOS classique.

Quand on veut réaliser un point mémoire permanent dans un circuit intégré, on a couramment recours à des technologies qui font appel à des doubles grilles et qui ne sont pas compatibles avec les procédés simples de réalisation de circuits intégrés CMOS. Ainsi, dans un circuit réalisé en technologie CMOS classique, pour mémoriser de façon permanente des informations, on a recours ou bien à des points mémoire non programmables électriquement, réalisables par masquage lors de la fabrication du circuit, ou bien à des points mémoire de type fusible qui claquent par suite du passage d'un courant et dont l'état de basse ou haute impédance est ensuite détectable. Toutefois, ces éléments ont l'inconvénient d'occuper une place relativement importante et de ne pas toujours être fiables.

Ainsi, un objet de la présente invention est de prévoir un point mémoire dans une technologie CMOS qui soit de petite dimension.

Un autre objet de la présente invention est de prévoir un tel point mémoire qui soit assemblable en réseau et simplement programmable et adressable électriquement.

Pour atteindre ces objets, la présente invention prévoit d'utiliser comme point mémoire un transistor MOS de taille minimum dont la résistance grille-caisson est modifiable par passage d'un courant circulant depuis le drain et la source vers le caisson, le point mémoire étant programmé ou non selon l'état de sa grille pendant la phase de programmation.

Plus particulièrement, la présente invention prévoit l'utilisation d'un transistor MOS classique comme point mémoire dans laquelle, pendant la programmation, le caisson du transistor MOS est connecté à un potentiel de référence, le drain et la source sont connectés à une source de courant propre à polariser les jonctions de drain et de source en inverse et en avalanche de telle façon que la zone de charge d'espace s'étende sur toute la longueur du canal, la grille est mise au potentiel de référence si le point mémoire ne doit pas être programmé et à un potentiel distinct du potentiel de référence si le point mémoire doit être programmé ; et pendant la lecture, des moyens sont prévus pour détecter un état de haute ou de basse impédance entre grille et caisson.

Selon un mode de réalisation de la présente invention, la longueur de grille du transistor MOS est inférieure à 0,5 µm.

Selon un mode de réalisation de la présente invention, le transistor MOS est un transistor à canal P formé dans un caisson N d'une couche épitaxiée de type P.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente une vue en coupe schématique d'un point mémoire selon la présente invention ;
la figure 2 représente le schéma électrique d'un point mémoire selon la présente invention ;
la figure 3 représente une vue en coupe d'un assemblage de points mémoire selon la présente invention associé à deux transistors MOS complémentaires ;
la figure 4 représente un circuit associant des points mémoire selon la présente invention ; et
la figure 5 représente l'utilisation d'un point mémoire selon la présente invention pour la programmation d'une bascule prenant un état déterminé à la mise sous tension.

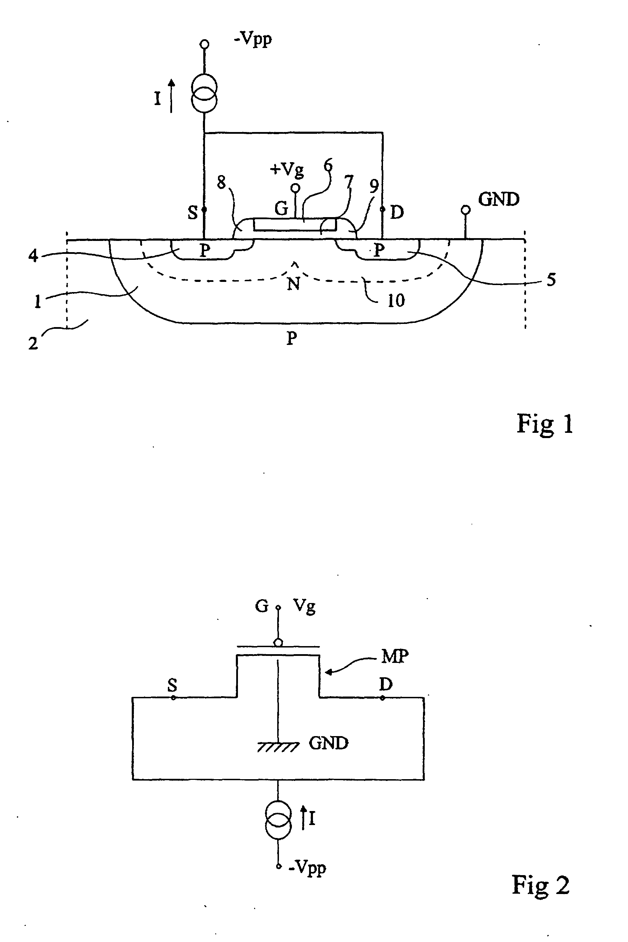

La figure 1 représente de façon schématique une vue en coupe d'un transistor MOS fabriqué selon des techniques classiques de fabrication de circuits CMOS. Le transistor MOS de la figure 1 est un transistor à canal P formé dans un caisson 1 de type N lui-même formé dans un substrat 2 de type P, généralement une couche épitaxiée. La référence 4 désigne une diffusion de source de type P, la référence 5 désigne une diffusion de drain de type P, la référence 6 désigne une grille conductrice formée au-dessus d'une région de canal du transistor MOS avec interposition d'une couche d'un isolant de grille 7. De façon classique, il est prévu des espaceurs 8 et 9 de part et d'autre de la grille pour définir des régions de source et de drain de type LDD. Dans les technologies modernes, la longueur de canal, c'est-à-dire la distance entre les régions en regard de la source et du drain, est inférieure à 0,5 µm, par exemple de l'ordre de 0,35 µm. Ainsi, le transistor représenté en figure 1 ne diffère en rien des transistors à canal P classiques formés dans un caisson N dans une technologie CMOS où les transistors N sont par contre formés directement dans la couche épitaxiée 2.

Le transistor selon la présente invention se distingue des transistors antérieurs par son utilisation et les polarisations qui lui sont appliquées.

Le caisson N est mis à un potentiel de référence GND, couramment la masse. On rappellera que, par contre, le caisson N des transistors à canal P d'un circuit CMOS est connecté au potentiel positif le plus élevé du circuit, couramment désigné par l'appellation VDD.

Pour programmer le point mémoire constitué par le transistor représenté en figure 1, on fait circuler un courant entre le caisson 1 et l'ensemble du drain et de la source qui est connecté à un potentiel négatif -Vpp par l'intermédiaire d'une source de courant I. La tension est suffisante pour mettre les jonctions PN du drain et de la source en inverse et en avalanche. Si le transistor est suffisamment petit, la zone de charge d'espace associée aux jonctions en avalanche s'étend comme cela est représenté par la ligne en pointillés 10 sur toute la longueur du canal sous la grille. Ainsi, cette zone constitue un réservoir de porteurs chauds à haute énergie. On peut choisir l'état du point mémoire pendant cette phase de programmation en fonction du potentiel Vg appliqué à la grille G. Si le potentiel Vg est au potentiel de référence GND, les porteurs chauds ne seront pas attirés par la grille et rien ne se passe. Par contre, si la grille est mise à un potentiel Vg distinct de celui du substrat, cette grille attirera des électrons si son potentiel est positif ou des trous si son potentiel est négatif. Dans les deux cas, la traversée de la couche isolante mince 7, couramment une couche d'oxyde, par ces porteurs libres à haute énergie dégradera les caractéristiques d'isolement de la couche mince isolante qui deviendra alors relativement conductrice, et à la limite provoquera un claquage de cette couche mince. Bien entendu, de préférence, on appliquera un potentiel positif proche de VDD à la grille car cela est plus simple dans des applications pratiques comme on le verra ci-après.

Pour lire le point mémoire, on déconnecte le drain et la source du potentiel -Vpp et, ou bien on les laisse en l'air, ou bien, et de préférence, on les connecte au potentiel de référence GND. Alors, pendant chaque lecture, on applique une tension Vg sur la grille et on détecte le courant passant entre la grille et le caisson. Un courant faible correspondra à un point mémoire non-programmé et un courant plus élevé correspondra à un point mémoire programmé.

En d'autres termes, le point mémoire selon la présente invention constitue un anti-fusible, c'est-à-dire un composant qui présente normalement une haute impédance et dont l'impédance chute à une valeur faible après programmation.

Des essais effectués par la demanderesse sur des transistors MOS à canal P d'une longueur de grille de 0,35 µm ont donné des résultats particulièrement satisfaisants. Pour la programmation, on a connecté le caisson 1 à la masse (0 volt), on a choisi une source de courant I de 8 milliampères, et on a appliqué à la grille ou bien une tension nulle (0 volt) ou bien une tension de programmation de 2,7 V (cette tension de 2,7 V correspondant à la tension d'alimentation VDD normale du circuit (3,5 V) moins une tension de seuil de transistor). Ensuite, pendant la phase de lecture, on a mis le caisson, la source et le drain à 0 V et on a appliqué 2,7 V à la grille. On a alors constaté pour un dispositif programmé un courant de l'ordre de 10⁻² à 10⁻³ ampères (1 à 10 mA) et pour un dispositif non-programmé un courant de l'ordre de 10⁻¹⁰ à 10⁻¹¹ ampères (10 à 100 pA). On constate que la différence de seuil entre les dispositifs programmés et non-programmés est particulièrement importante (supérieure à 6 décades). Bien entendu, il ne s'agit là que d'un exemple particulier réalisé par la demanderesse sur un dispositif expérimental simple et, selon les technologies de fabrication CMOS utilisées, ces résultats pourraient être quelque peu différents.

La figure 2 représente le schéma électrique équivalent du composant de la figure 1. Le point mémoire MP est représenté par un transistor MOS à canal P dont la source et le drain sont connectés à une source de courant I (pendant la phase de programmation) et dont le caisson est relié à la masse GND.

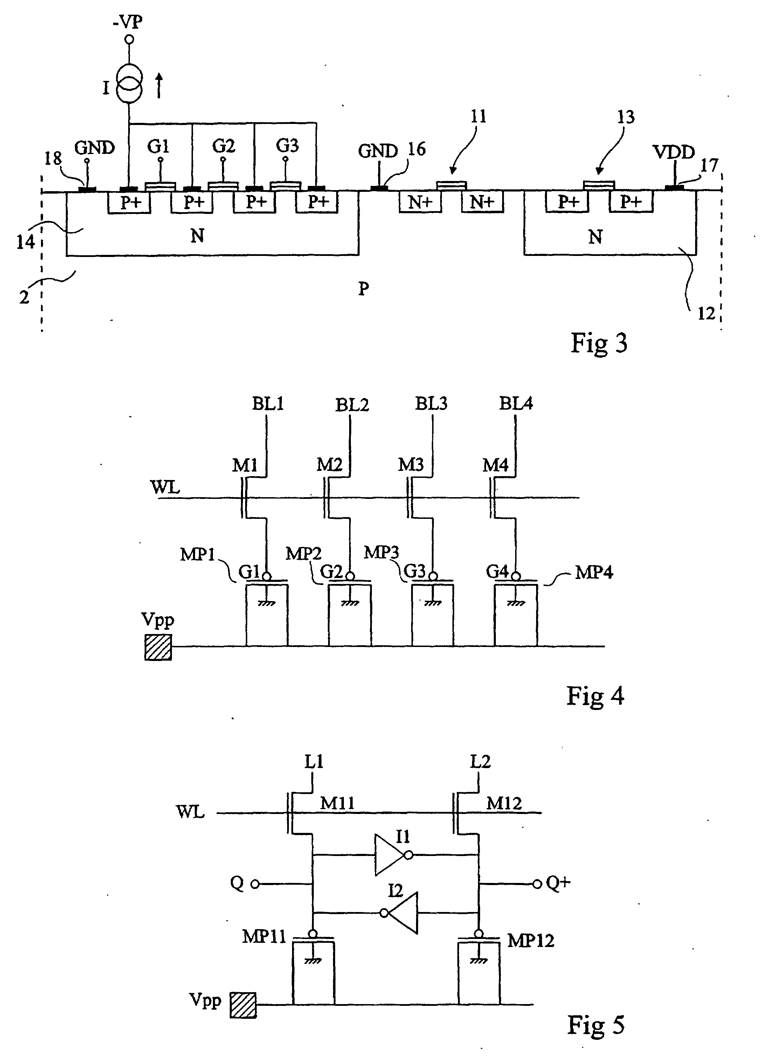

La figure 3 représente une vue en coupe schématique d'une portion d'un circuit intégré CMOS. Cette figure est extrêmement schématique et a uniquement pour but de montrer qu'il n'y a pas de problème particulier d'isolement des points mémoire selon l'invention par rapport aux autres composants du circuit. Notamment, on n'a pas représenté d'espaceurs autour des grilles des transistors. Dans cette figure, on peut voir à droite et côte à côte dans un substrat 2 (une couche épitaxiée) de type P un transistor MOS à canal N 11 et, dans un caisson 12 de type N, un transistor MOS à canal P 13. Les points mémoire selon la présente invention sont formés dans un caisson 14 de type N. On a représenté trois points mémoire dont les grilles sont désignées par G1, G2 et G3. Les drains et les sources sont connectés ensemble à une source de courant I reliée à une source de tension -Vpp. De façon classique, le substrat (couche épitaxiée) 2 est connecté par l'intermédiaire d'un contact 16 à la masse et le caisson 12 des transistors à canal P 13 est relié par l'intermédiaire d'une métallisation 17 au potentiel VDD. Le caisson 14 est relié par l'intermédiaire d'une métallisation 18 également à la masse GND. On constate qu'il ne se pose aucun problème d'isolement et de circulation de courant parasite.

La figure 4 représente un exemple simple sous forme de circuit d'un assemblage de points mémoire selon la présente invention. Quatre points mémoire MP1 à MP4 ont leurs drains et sources reliés à une borne Vpp, leur substrat (ou caisson) relié à la masse, et leurs grilles G1 à G4 reliées à des lignes BL1 à BL4 par l'intermédiaire de transistors MOS à canal N M1 à M4 dont les grilles sont reliées à une ligne WL (de façon classique WL désigne une ligne de mot de la mémoire, et BL une ligne de bits de cette mémoire).

Pour la programmation, on connecte la borne Vpp à une source de courant comme cela a été indiqué précédemment, la ligne WL est adressée et les lignes BL1 à BL4 sont, selon que l'on veut programmer ou non le transistor correspondant, mises à VDD ou à la masse par le décodeur qui leur est associé.

Lors de l'opération de lecture, la borne Vpp est laissée en l'air ou mise à la masse et chacune des lignes BL1 à BL4 est adressée par l'intermédiaire d'un amplificateur de lecture qui détecte le courant qui la traverse.

On notera que, une fois qu'une cellule mémoire MP1 à MP4 a été programmée, son état est irréversible. Il reste toutefois possible de modifier un circuit selon la présente invention à tout instant en changeant un point mémoire non-programmé en un point mémoire programmé. De même, on pourra prévoir des circuits logiques permettant d'inhiber des points mémoire programmés pour transférer l'information correspondante sur un point mémoire non-programmé.

La figure 5 représente un exemple de bascule qui se met dans un état logique déterminé à la suite d'une mise sous tension grâce à des points mémoire selon la présente invention. La bascule est représentée schématiquement sous forme de deux inverseurs tête-bêche I1 et I2. Elle comprend des sorties complémentaires Q et Q*. Deux points mémoire MP1 et MP2 sont respectivement connectés aux deux sorties Q et Q*. Chaque point mémoire est relié à une ligne de programmation L1, L2 validée par l'intermédiaire de transistors M11 et M12 validables par une ligne de mots WL. La programmation de l'un ou l'autre des points mémoire s'effectue de la façon décrite précédemment et ainsi la bascule se fige dans un état déterminé. On notera que selon un avantage de l'invention, cette bascule ne présente aucune consommation au repos.

Bien entendu, la présente invention est susceptible de diverses variantes qui apparaîtront à l'homme de l'art. Par exemple, dans une technologie de fabrication de transistors CMOS sur couche épitaxiée de type N, ce seront de préférence des transistors MOS à canal N formés dans des caissons P qui seront utilisés comme point mémoire selon la présente invention. En outre, même dans une technologie de transistors CMOS sur couche épitaxiée de type P, on pourra former des points mémoire selon la présente invention à partir de transistors MOS à canal N à condition d'assurer un isolement convenable, par exemple par des technologies à double ou triple caisson.

## Revendications

1. Utilisation d'un transistor MOS classique comme point mémoire dans laquelle :
pendant la programmation :
- le caisson (1) du transistor MOS est connecté à un potentiel de référence ;
- le drain (5) et la source (4) sont connectés à une source de courant (-Vpp, I) propre à polariser les jonctions de drain et de source en inverse et en avalanche de telle façon que la zone de charge d'espace s'étende sur toute la longueur du canal ;
- la grille (6) est mise au potentiel de référence si le point mémoire ne doit pas être programmé et à un potentiel distinct du potentiel de référence si le point mémoire doit être programmé ;
pendant la lecture, des moyens sont prévus pour détecter un état de haute ou de basse impédance entre grille et caisson.

2. Point mémoire selon la revendication 1, **caractérisé en ce que** la longueur de grille du transistor MOS est inférieure à 0,5 µm.

3. Point mémoire selon la revendication 1, **caractérisé en ce qu'**il comprend un transistor MOS à canal P formé dans un caisson N d'une couche épitaxiée de type P.

## Claims

1. A method for using a conventional MOS transistor as a memory point, in which:
during the programming:
- the well (1) of the MOS transistor is connected to a reference potential;
- the drain (5) and the source (4) are connected to a current source (-Vpp, I) adapted to biasing the drain and source junctions in reverse and in avalanche so that the space charge region extends along the entire channel length;
- the gate (6) is set to the reference potential if the memory point does not have to be programmed and to a potential distinct from the reference potential if the memory point has to be programmed;
during the reading, means are provided to detect a high or low impedance state between the gate and the well.

2. The memory point of claim 1, **characterized in that** the gate length of the MOS transistor is lower than 0.5 µm.

3. The memory point of claim 1, **characterized in that** the MOS transistor is a P-channel transistor formed in an N well of a P-type epitaxial layer.

## Patentansprüche

1. Verfahren zur Verwendung eines herkömmlichen MOS-Transistors als Speicherpunkt, bei welchem
während der Programmierung:
- der Kasten bzw. Graben (1) des Transistors mit einem Bezugspotential verbunden wird;
- Drain(5) und Source(4) mit einer Stromquelle (-Vpp, I) verbunden werden, die geeignet ist, die Drain- und Source- p,n-Übergänge in Sperrichtung und in Lawinendurchbruchzustand vorzuspannen, derart, dass die Raumladungszone sich über die gesamte Länge des Kanals erstreckt;
- das Gate (6) auf das Bezugspotential vorgespannt wird, falls der Speicherpunkt nicht programmiert werden soll, und auf ein von dem Bezugspotential verschiedenes Potential vorgespannt wird, falls der Speicherpunkt programmiert werden soll;
während dem Lesen
werden Mittel vorgesehen zum Nachweis eines Zustands hoher oder niedriger Impedanz zwischen dem Gate und dem Graben.

2. Speicherpunkt nach Anspruch 1, **dadurch gekennzeichnet, dass** die Gate-Länge des MOS-Transistors kleiner als 0,5 µm ist.

3. Speicherpunkt nach Anspruch 1, **dadurch gekennzeichnet, dass** er einen P-Kanal-MOS-Transistor umfasst, der in einem N-Graben einer Epitaxialschicht vom P-Typ ausgebildet ist.
